# EUROPÄISCHE PATENTSCHRIFT

(11) **EP 2 040 526 B1**
(45) Veröffentlichungstag und Bekanntmachung des Hinweises auf die Patenterteilung: **07.11.2012**
(21) Anmeldenummer: 08105153.4
(22) Anmeldetag: 27.08.2008
(51) Int. Cl.: H05K 5/00, H05K 7/20, H05K 1/02, H05K 3/28, B60R 16/023

(54) **Elektrisches Gerät, insbesondere Steuergerät für ein Kraftfahrzeug**
Electric device, in particular control device for a motor vehicle
Appareil électrique, en particulier appareil de commande pour un véhicule automobile

(30) Priorität: 21.09.2007 DE 102007045261
(43) Veröffentlichungstag der Anmeldung: 25.03.2009
(73) Patentinhaber: Continental Automotive GmbH, 30165 Hannover (DE)
(72) Erfinder: Smirra, Karl, 83512, Wasserburg (DE); Bernhardt, Andreas, 93173, Wenzenbach (DE); Schingale, Angelika, 93059, Regensburg (DE)

(56) Entgegenhaltungen:
- EP-A- 0 116 396
- DE-A1- 19 533 298
- US-A- 5 914 864
- US-A1- 2003 161 110
- US-B1- 6 212 074

## Beschreibung

Die Erfindung betrifft ein elektrisches Gerät, insbesondere ein Steuergerät für ein Kraftfahrzeug.

Ein derartiges Steuergerät kann beispielsweise ein Motor- oder Getriebesteuergerät sein, welches unmittelbar an einer Anbaufläche des Motors bzw. Getriebes ist. Aufgrund ihrer Einsatzbedingungen müssen solche elektrischen Geräte eine hohe Robustheit gegenüber Vibrationen, Umwelteinflüssen, den vorherrschenden Umgebungstemperaturen und hohen Temperaturschwankungen aufweisen. Von besonderer Bedeutung für die Zuverlässigkeit sind hierbei nicht nur die hohen, absoluten auszuhaltenden Temperaturen bis zu 140 °C, sondern auch eine Vielzahl an Temperaturwechseln mit großen Temperaturunterschieden.

Üblicherweise umfasst das elektrische Gerät eine Trägerplatte, auf welcher eine strukturierte, elektrisch leitende Schicht aufgebracht ist, wobei mit der elektrisch leitenden Schicht eine Anzahl an elektrischen Bauelementen über ein Verbindungsmittel verbunden ist.

Die US 5,914,864 A offenbart ein elektrisches Gerät mit einer Trägerplatte, auf welcher eine strukturierte, elektrisch leitende Schicht aufgebracht ist, wobei mit der elektrisch leitenden Schicht zumindest ein elektrisches Bauelement über ein Verbindungsmittel verbunden ist, und ein relativ zu der Trägerplatte ortsfest angeordnetem Gehäusebauteil, welches das zumindest eine auf der Trägerplatte aufgebrachte Bauelement umgibt , und einen Niederhalter, der sich an dem Gehäusebauteil abstützt und das zumindest eine Bauelement unter Druck im Wesentlichen senkrecht gegen die Trägerplatte presst.

Die US 2003/0161110 A1 offenbart ein Steuergerät mit einem Gehäuse, einer PCB, einem Deckel und einem thermisch leitfähigen, elektrisch isolierenden Dämpfungselement auf Silikonbasis, wobei das Dämpfungselement zwischen dem Deckel und der PCB angeordnet ist.

Aus Kostengründen ist es wünschenswert, wenn die Trägerplatte eine Leiterplatte ist, da bei dieser die Herstellung der elektrischen Verbindungen zu den elektrischen Bauelementen über ein einfach zu handhabendes Lot vorgenommen werden kann. Von Nachteil ist dabei, dass die Lotverbindungen bei den Einsatzbedingungen mit den hohen Temperaturen und Temperaturschwankungen aufgrund der unterschiedlichen thermischen Ausdehnungskoeffizienten des Leiterplattenmaterials und der Bauelemente aufschmelzen und aufbrechen können.

In der Praxis wird als Trägerplatte deshalb üblicherweise ein keramisches Substrat, z.B. ein LTCC-Substrat (LTCC = Low Temperature Cofired Ceramics) verwendet. Zur Herstellung der elektrischen Verbindung der elektrischen Bauelemente mit der auf dem Substrat aufgebrachten, strukturierten elektrisch leitenden Schicht wird ein Leitkleber verwendet. Hierdurch können die bei hohen Temperaturen und starken Temperaturschwankungen oben beschriebenen Probleme beseitigt werden. Nachteilig bei der Verwendung eines keramischen Substrats sind die im Vergleich zu Leiterplattenmaterial höheren Kosten. Ferner werden die Kosten auch dadurch in die Höhe getrieben, dass aufgrund der Verwendung von Leitkleber als Verbindungsmittel die Anschlusskontakte der elektrischen Bauelemente aus einem an das Material des Leitklebers angepassten Werkstoff gebildet werden müssen. Die Bereitstellung der elektrischen Bauelemente ist hierdurch ebenfalls mit bedeutend höheren Kosten verbunden.

Es ist daher Aufgabe der vorliegenden Erfindung, ein elektrisches Gerät, insbesondere ein Steuergerät für ein Kraftfahrzeug, anzugeben, welches bei Einsatztemperaturen von 140 °C bis 160 °C in Verbindung mit starken Temperaturschwankungen eine hohe Zuverlässigkeit bei gleichzeitig geringen Herstellungskosten aufweist.

Diese Aufgabe wird durch die Merkmale des Patentanspruches 1 gelöst. Vorteilhafte Ausgestaltungen ergeben sich aus den abhängigen Patentansprüchen.

Ein erfindungsgemäßes elektrisches Gerät, insbesondere ein Steuergerät für ein Kraftfahrzeug, umfasst eine Trägerplatte, auf welcher eine strukturierte elektrisch leitende Schicht aufgebracht ist, wobei mit der elektrisch leitenden Schicht zumindest ein elektrisches Bauelement über ein Verbindungsmittel verbunden ist. Das elektrische Gerät umfasst weiter ein relativ zu der Trägerplatte ortsfest angeordnetes Gehäusebauteil, welches das zumindest eine auf der Trägerplatte aufgebrachte Bauelement umgibt. Ein Niederhalter stützt sich an dem Gehäusebauteil ab und presst das zumindest eine Bauelement unter Druck im Wesentlichen senkrecht gegen die Trägerplatte.

Um den Betriebsbedingungen über eine lange Zeit standhalten zu können, ist der Niederhalter vorteilhafterweise aus einem temperaturbeständigen Material gebildet, so dass der Niederhalter insbesondere Temperaturen über 150 °C, bevorzugt über 160 °C, ohne irreversible Änderung seiner Eigenschaften aushält.

Insbesondere weist der Niederhalter eine Schicht aus einem Schaumstoff mit zumindest abschnittsweise federnden Eigenschaften auf. Die Schicht kann beispielsweise aus einem Silikonschaum gebildet sein, welcher einerseits die geforderte Temperaturbeständigkeit aufweist und andererseits die notwendigen federnden Eigenschaften aufbringt, um ausreichend Druck auf die Bauelemente ausüben zu können.

Im Besonderen umfasst der Niederhalter zumindest eine weitere, im Wesentlichen nicht komprimierbare Schicht. Diese weitere Schicht kann beispielsweise als Abstandshalter dienen. Hierdurch kann die federnde Schicht dünner ausgeführt werden und muss sich nicht unmittelbar an dem Gehäusebauteil abstützen.

Zweckmäßigerweise ist die Schicht mit federnden Eigenschaften zwischen dem Gehäusebauteil und der weiteren Schicht oder alternativ zwischen der weiteren Schicht und dem zumindest einen Bauelement angeordnet. Daher ist es nicht relevant, ob die elastische, federnde Eigenschaften aufweisende Schicht in direktem Kontakt mit den jeweiligen Bauelementen steht oder die Kraftübertragung über eine zwischen der elastischen Schicht und dem betreffenden Bauelement eingebrachten weiteren Schicht erfolgt. Dies schafft Freiheitsgrade bei der Ausgestaltung des Niederhalters.

Die Erfindung weist den Vorteil auf, dass als Trägerplatte eine Leiterplatte und als Verbindungsmittel ein Lot verwendbar ist. Hierdurch bedingt können als elektrische Bauelemente herkömmliche Bauelemente verwendet werden, welche ein Gehäuse, z.B. aus einem Kunststoff aufweisen, aus welchem verzinnte Anschlusselemente ragen, mit denen die Bauelemente mit der elektrisch leitenden Schicht unter Verwendung von Lot verlötet werden können. Durch den Niederhalter ist ferner die Zuverlässigkeit des elektrischen Geräts unter hohen Temperaturen bis zu 160 °C und insbesondere hohen Temperaturschwankungen und Vibrationen sichergestellt, da eine Ablösung der Bauelemente von der Trägerplatte aufgrund eines sich erweichenden Verbindungsmittels verhindert wird. Darüber hinaus ist auch eine Fixierung in der Ebene der Trägerplatte sichergestellt. Dies gilt auch dann, wenn die Trägerplatte einen anderen thermischen Ausdehnungskoeffizienten als die elektrischen Bauelemente und das Verbindungsmittel aufweist.

Durch die hohen Umgebungstemperaturen kann das Verbindungsmittel, sofern dieses als Lot ausgebildet ist, zeitweilig aufschmelzen und aufgrund der thermischen Ausdehnung der Trägerplatte unter Umständen geschwächt werden. Durch den Niederhalter, welcher das oder die Bauelemente senkrecht gegen die Ebene der Trägerplatte presst, ist jedoch zu jedem Zeitpunkt sichergestellt, dass der elektrische Kontakt nicht verschlechtert wird. Dies gilt auch, wenn das elektrische Gerät starken Temperaturzyklen bzw. -schwankungen und Vibrationen ausgesetzt ist und das Verbindungsmittel wieder erstarrt.

Aufgrund der Möglichkeit, herkömmliche, in großen Stückzahlen gefertigte Komponenten verwenden zu können, weist das elektrische Gerät gegenüber bislang eingesetzten elektrischen Geräten, welche auf besondere Materialien und Materialkombinationen zurückgreifen müssen, einen wesentlich günstigeren Herstellungspreis auf.

Zweckmäßigerweise ist der Niederhalter derart ausgestaltet, dass dieser jedes Bauelement einer Mehrzahl an Bauelementen in etwa mit der gleichen Kraft beaufschlagt. Hierdurch ist sichergestellt, dass die Verbindung zwischen einem elektrischen Bauelement und der Trägerplatte aufgrund der vorherrschenden Betriebsbedingungen nicht aufgrund eines zu geringen oder eines zu großen Drucks geschwächt wird.

In einer ersten Variante weist der Niederhalter im Bereich des zumindest einen Bauelements eine jeweilige, an die geometrischen Maße des Bauelements angepasste Kavität auf. Insbesondere sind die Tiefen einer jeweiligen Kavität an die Höhen der jeweiligen Bauelemente angepasst, um die gewünschte, gleichmäßige Druckbeaufschlagung eines jeden Bauelements zu erhalten. Es ist hierbei zweckmäßig, eine Kavität aus Toleranzgründen etwas breiter als das Bauelement auszugestalten, das in die betreffende Kavität ragt. Eine Kavität kann derart ausgebildet sein, dass auch mehrere Bauelemente in diese hineinragen, was bei gleicher Bauhöhe der Bauelemente zweckmäßig sein kann.

In einer anderen Ausgestaltung besteht der Niederhalter aus einem komprimierbaren Material, das zwischen dem Gehäusebauteil und der Trägerplatte angeordnet ist und die Struktur des zumindest einen auf der Leiterplatte angeordneten Bauelements nachbildet. Bei dieser Ausgestaltung wird das Material zwischen das Gebäudebauteil und die mit den Bauelementen bestückte Trägerplatte eingebracht und beim Zusammenfügen des Gehäusebauteils und der bestückten Trägerplatte komprimiert. Das Material des Niederhalters ist derart gewählt, dass es sich bis zu einem bestimmten Grad z.B. irreversibel oder reversibel verformt und dabei die Struktur der Oberfläche der bestückten Trägerplatte nachbildet. Die komprimierten Bereiche sorgen für die gewünschte Druckbeaufschlagung eines jeweiligen Bauelements.

In einer weiteren Variante umfasst der Niederhalter zumindest ein Federelement, welches einem jeweiligen Bauelement zugeordnet ist und die Druckbeaufschlagung bewirkt. Das Federelement kann beispielsweise säulenartig ausgebildet sein. Das Federelement kann auch die Gestalt einer Schraubenfeder oder einer beliebigen anderen Federform haben.

Das Gehäusebauteil ist gemäß einer weiteren Ausführungsform ein Deckel, der das zumindest eine Bauelement hermetisch in einem zwischen der Trägerplatte und dem Gehäusebauteil gebildeten Hohlraum einschließt. Das Gehäusebauteil kann zur hermetischen Abdichtung beispielsweise über eine Dichtung mit der Trägerplatte verbunden sein.

Zweckmäßigerweise füllt der Niederhalter den Hohlraum im Wesentlichen vollständig aus. Hierdurch wird Luft, welche einen Isolator ausbildet, verdrängt. Dadurch kann die Wärmeabfuhr von den Bauelementen über das Gehäusebauteil verbessert werden. Es ist deshalb zweckmäßig, wenn der Niederhalter aus einem gut Wärme leitenden Material ausgebildet ist.

Die Erfindung wird nachfolgend weiter anhand der Figuren erläutert. Es zeigen:
- Fig. 1: ein erstes Ausführungsbeispiel eines gattungsgemä-βen elektrischen Geräts in einer Querschnittsdarstellung,
- Fig. 2: ein zweites Ausführungsbeispiel eines gattungsgemäßen elektrischen Geräts in einer Querschnittsdarstellung, und
- Fig. 3: ein Ausführungsbeispiel eines erfindungsgemäßen elektrischen Geräts in einer Querschnittsdarstellung.

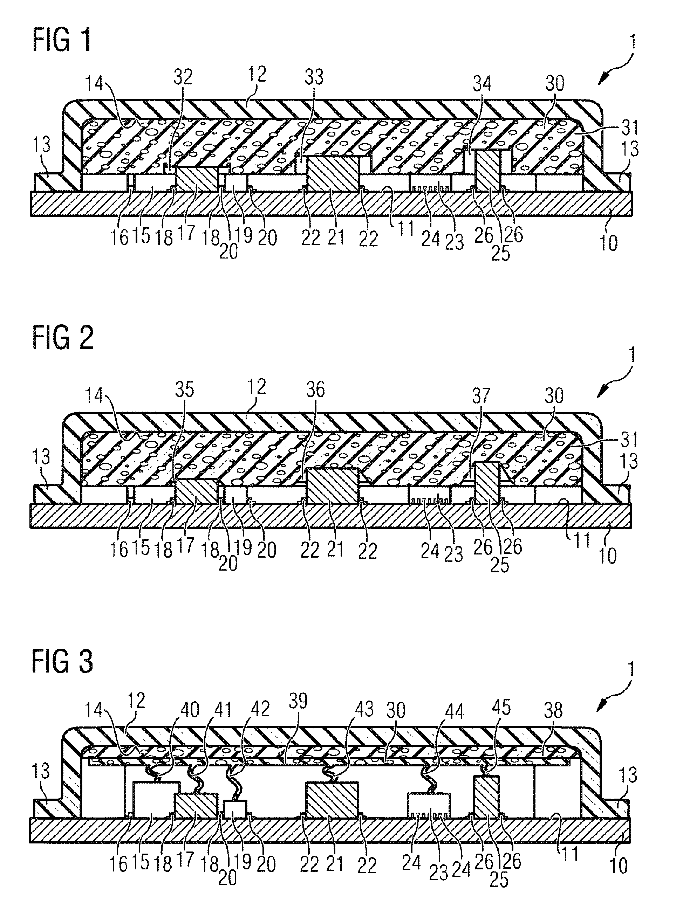

Die Figuren 1 bis 3 zeigen jeweils in einer Querschnittsdarstellung verschiedene Ausführungsbeispiele eines elektrischen Geräts 1, wobei die Figuren 1 und 2 zum besseren Verständnis der Erfindung Beispiele aus dem Stand der Technik zeigen. Der konstruktive Aufbau sämtlicher Ausführungsvarianten ist identisch. Die Ausführungsbeispiele unterscheiden sich jeweils in einem nachfolgend näher beschriebenen Niederhalter 30.

Unter Bezugnahme auf Fig. 1 wird die erste Ausführungsvariante des elektrischen Geräts 1 beschrieben. Auf einer Trägerplatte 10 ist eine strukturierte, elektrisch leitende Schicht 11 aufgebracht, welche als Leiterzugstruktur ausgebildet ist. Die Leiterzugstruktur 11 dient dazu, eine elektrische Verbindung zu elektrischen Bauelementen 15, 17, 19, 21, 23, 25 herzustellen, welche über ein Verbindungsmittel mit der Leiterzugstruktur 11 elektrisch verbunden sind. Die Trägerplatte 10 ist beispielsweise als Leiterplatte, z.B. aus FR4, ausgebildet, so dass als Verbindungsmittel zwischen der Leiterzugstruktur 11 und jeweiligen Anschlusselementen 16, 18, 20, 22, 24, 26 jeweiliger elektrischer Bauelemente 15, 17, 19, 21, 23, 25 Lot zum Einsatz gelangen kann. Ein elektrisches Bauelement kann z.B. einen in einem Gehäuse angeordneten Halbleiterchip, ein passives Bauelement und dergleichen darstellen. Sämtliche der elektrischen Bauelemente 15, 17, 19, 21, 23, 25 sind auf einer Hauptseite der Trägerplatte 10 angeordnet. Mit der gegenüberliegenden Hauptseite kann die Trägerplatte 10 auf eine Wärmesenke, z.B. eine Metallplatte, montiert werden. Über diese ist eine Montage an einer Anbaufläche, z.B. einem Motor oder einem Getriebe eines Kraftfahrzeugs, möglich. Zum Schutz vor den am Einbauort vorherrschenden Umgebungsbedingungen ist ein Gehäusebauteil 12 vorgesehen. Das als Deckel ausgebildete Gehäusebauteil 12 ist über einen ringförmig verlaufenden Flansch 13 mit der Trägerplatte 10 verbunden. Zwischen dem Flansch 13 und der Trägerplatte 10 kann zur Herstellung einer hermetischen Dichtigkeit eine Dichtung (nicht dargestellt) angeordnet sein.

Um bei hohen Umgebungstemperaturen (z.B. hervorgerufen durch das in einer Ölwanne des Getriebes angeordnete Gerät) bis ca. 140 °C zuzüglich einer Eigenerwärmung der elektrischen Bauelemente sowie starken Temperaturschwankungen und Vibrationen eine Schwächung oder Ablösung der elektrischen Verbindung zwischen den Bauelementen 15, 17, 19, 21, 23, 25 und der Leiterzugstrukturen zu vermeiden, ist ein Niederhalter 30 in einem Hohlraum zwischen dem Gehäusebauteil 12 und der mit den Bauelementen bestückten Trägerplatte 10 vorgesehen. Die Schwächung oder Ablösung kann aufgrund unterschiedlicher thermischer Ausdehnungskoeffizienten der Trägerplatte 10 sowie der darauf angeordneten und über das Verbindungsmittel mit der Leiterzugstruktur 11 verbundenen Bauelemente 15, 17, 19, 21, 23, 25 und Vibrationen hervorgerufen werden.

Im Ausführungsbeispiel der Fig. 1 füllt der Niederhalter 30 den Hohlraum nahezu vollständig aus, wodurch Luft, die bekanntermaßen isolierende Eigenschaften aufweist, verdrängt wird. Der Niederhalter 30 übernimmt hier zusätzlich eine Wärmeableitungsfunktion.

Der Niederhalter 30 besteht z.B. aus einem temperaturstabilen Schaumstoff 31, in welchen Kavitäten 32, 33, 34 eingebracht sind. Es versteht sich, dass auch die Bauelemente 15, 19 und 23 in entsprechende Kavitäten des Schaumstoffs 31 ragen können. Die Kavitäten 32, 33, 34 weisen eine an die Höhe der Bauelemente 15, 17, 19, 21, 23, 25 angepasste Tiefe auf. Hierdurch wird durch den Schaumstoff 31 auf jedes der Bauelemente 15, 17, 19, 21, 23, 25 ein in etwa gleich großer Druck ausgeübt, so dass die elektrischen Bauelemente 15, 17, 19, 21, 23, 25 durch den Schaumstoff 31 senkrecht zur Ebene der Trägerplatte 10 an diese gedrückt werden. Durch die Druckbeaufschlagung ist sichergestellt, dass bei den gegebenen Umgebungsbedingungen ein Ablösen der Bauelemente 15, 17, 19, 21, 23, 25 von der Trägerplatte 10 nicht auftreten kann. Hierdurch bleiben elektrische Verbindungen zwischen der Leiterzugstruktur 11 und jeweiligen Anschlusskontakten der Bauelemente auch unter widrigen Umständen intakt, so dass die Zuverlässigkeit des elektrischen Geräts trotz des Einsatzes kostengünstiger Materialien sichergestellt ist.

Im Ausführungsbeispiel gemäß Fig. 2 ist der Niederhalter 30 ebenfalls durch eine Schaumstoffschicht 31 gebildet. Im Gegensatz zur ersten Ausgestaltungsvariante weist diese im Bereich der Bauelemente 15, 17, 19, 21, 23, 25 jedoch keine Kavitäten auf. Vielmehr lässt sich der Schaumstoff 31 bis zu einem bestimmten Grad verformen und bildet dabei die Struktur der Oberfläche des mit den Bauelementen 15, 17, 19, 21, 23, 25 bestückten Trägerplatte 10 nach. Hierdurch werden Bereiche 35, 36, 37 ausgebildet, welche den senkrecht gegen die Trägerplatte 10 gerichteten Druck auf die Bauelemente 15, 17, 19, 21, 23, 25 ausüben. Um eine gleichmäßige Druckverteilung bzw. einen an die Gestalt des Bauelements angepassten Druck sicherstellen zu können, kann der Schaumstoff 31 z.B. abschnittsweise unterschiedliche Härtegrade aufweisen bzw. komprimierbar sein. Prinzipiell können die Bauelemente alternativ mit unterschiedlichen Drücken beaufschlagt werden.

In den Ausführungsbeispielen der Figuren 1 und 2 besteht der Niederhalter 30 jeweils aus einer einzigen Schicht aus Schaumstoff 31.

Das Ausführungsbeispiel der Fig. 3 beschreibt das erfindungsgemäße elektrische Gerät 1. Es kommt als Niederhalter 30 eine Anordnung zum Einsatz, bei der die Abbildung der Oberflächentopographie der mit den Bauelementen 15, 17, 19, 21, 23, 25 bestückten Trägerplatte 10 und der reversiblen Verformbarkeit zur Unterstützung der elektrischen Verbindungen durch getrennte Schichten 38, 39 erfolgt. Beide Schichten 38, 39 können z.B. aus einem Schaumstoff gebildet sein. Im Ausführungsbeispiel ist die Schicht 39 mit einer Anzahl an Federelementen 40, 41, 42, 43, 44, 45 versehen, wobei jedes Federelement einem der Bauelemente 15, 17, 19, 21, 23, 25 zugeordnet ist. Die Ausgestaltung der Federelemente kann beliebig erfolgen. Die Schicht 38 bildet einen stützenden Anteil, an welchem sich die Schicht 39 mit den Federelementen 40 bis 45 abstützen kann. Die Schicht 38 liegt hierzu an einer Innenseite 14 des Gehäusebauteils 12 an. Über die Ausgestaltung der Federelemente 40 bis 45 kann beispielsweise die Kraft eingestellt werden, mit welcher der Niederhalter 30 die Bauelemente 15, 17, 19, 21, 23, 25 gegen die Trägerplatte 10 presst.

## Patentansprüche

1. Elektrisches Gerät (1), insbesondere Steuergerät für ein Kraftfahrzeug, mit:
- einer Trägerplatte (10), auf welcher eine strukturierte, elektrisch leitende Schicht aufgebracht ist, wobei mit der elektrisch leitenden Schicht (11) zumindest ein elektrisches Bauelement (15, 17, 19, 21, 23, 25) über ein Verbindungsmittel verbunden ist,
- einem relativ zu der Trägerplatte (10) ortsfest angeordnetem Gehäusebauteil (12), welches das zumindest eine auf der Trägerplatte (10) aufgebrachte Bauelement (15, 17, 19, 21, 23, 25) umgibt, und
- einem Niederhalter (30), der sich an dem Gehäusebauteil (12) abstützt und das zumindest eine Bauelement (15, 17, 19, 21, 23, 25) unter Druck im Wesentlichen senkrecht gegen die Trägerplatte (10) presst,
**dadurch gekennzeichnet, dass** der Niederhalter (30) aus einem temperaturbeständigen Material gebildet ist und Temperaturen über 150 °C, bevorzugt über 160 °C ohne irreversible Änderung seiner Eigenschaften aushält, und dass der Niederhalter (30) eine Schicht (31; 39) aus einem Schaumstoff mit zumindest abschnittsweise federnden Eigenschaften und zumindest eine weitere im Wesentlichen nicht komprimierbare Schicht (38) umfasst, wobei die Schicht (31, 39) mit federnden Eigenschaften zwischen dem Gehäusebauteil (12) und der weiteren Schicht (38) oder zwischen der weiteren Schicht (38) und dem zumindest einen Bauelement (15, 17, 19, 21, 23, 25) angeordnet ist.

2. Gerät nach Anspruch 1, bei dem der Niederhalter (30) jedes Bauelement (15, 17, 19, 21, 23, 25) einer Mehrzahl an Bauelementen (15, 17, 19, 21, 23, 25) in etwa mit der gleichen Kraft beaufschlagt.

3. Gerät nach Anspruch 1 oder 2, bei dem die Schicht (31; 39) aus einem Silikonschaum gebildet ist.

4. Gerät nach einem der Ansprüche 1 bis 3 , bei dem der Niederhalter (30) im Bereich des zumindest einen Bauelements (15, 17, 19, 21, 23, 25) eine jeweilige, an die geometrischen Maße des Bauelements (15, 17, 19, 21, 23, 25) angepasste Kavität (32, 33, 34) aufweist.

5. Gerät nach einem der Ansprüche 1 bis 3 , bei dem der Niederhalter (30) aus einem komprimierbaren Material besteht, das zwischen dem Gehäusebauteil (12) und der Trägerplatte (10) angeordnet ist und die Struktur des zumindest einen auf der Leiterplatte (10) angeordneten Bauelements (15, 17, 19, 21, 23, 25) nachbildet.

6. Gerät nach einem der Ansprüche 1 bis 3 , bei dem der Niederhalter (30) zumindest ein Federelement (40, 41, 42, 43, 44, 45) umfasst, welches einem jeweiligen Bauelement (15, 17, 19, 21, 23, 25) zugeordnet ist und die Druckbeaufschlagung bewirkt.

7. Gerät nach einem der vorherigen Ansprüche, bei dem die Trägerplatte (10) eine Leiterplatte und das Verbindungsmittel ein Lot ist.

8. Gerät nach einem der vorherigen Ansprüche, bei dem das Gehäusebauteil (12) ein Deckel ist, der das zumindest eine Bauelement (15, 17, 19, 21, 23, 25) hermetisch in einem zwischen der Trägerplatte (10) und dem Gehäusebauteil (12) gebildeten Hohlraum einschließt.

9. Gerät nach Anspruch 8 , bei dem der Niederhalter (30) den Hohlraum im Wesentlichen vollständig ausfüllt.

## Claims

1. Electrical device (1), in particular control device for a motor vehicle, having:
- a support plate (10) on which a patterned, electrically conductive layer is mounted, with at least one electrical component (15, 17, 19, 21, 23, 25) being connected to the electrically conductive layer (11) by means of a connecting means,
- a housing component (12) which is arranged in a stationary manner relative to the support plate (10) and which surrounds the at least one component (15, 17, 19, 21, 23, 25) which is mounted on the support plate (10), and
- a holding-down means (30) which is supported on the housing component (12) and presses the at least one component (15, 17, 19, 21, 23, 25) against the support plate (10) under pressure in a substantially perpendicular manner,
**characterized in that** the holding-down means (30) is formed from a temperature-resistant material and withstands temperatures of over 150°C, preferably of over 160°C, without its properties being irreversibly changed, and **in that** the holding-down means (30) comprises a layer (31; 39) which is composed of a foam with at least partially resilient properties and at least one further substantially incompressible layer (38), with the layer (31, 39) with resilient properties being arranged between the housing part (12) and the further layer (38) or between the further layer (38) and the at least one component (15, 17, 19, 21, 23, 25).

2. Device according to Claim 1, in which the holding-down means (30) acts on each component (15, 17, 19, 21, 23, 25) of a plurality of components (15, 17, 19, 21, 23, 25) approximately with the same force.

3. Device according to Claim 1 or 2, in which the layer (31; 39) is formed from a silicone foam.

4. Device according to one of Claims 1 to 3, in which the holding-down means (30) has, in the region of the at least one component (15, 17, 19, 21, 23, 25), a respective cavity (32, 33, 34) which is matched to the geometric dimensions of the component (15, 17, 19, 21, 23, 25).

5. Device according to one of Claims 1 to 3, in which the holding-down means (30) is composed of a compressible material which is arranged between the housing component (12) and the support plate (10) and replicates the structure of the at least one component (15, 17, 19, 21, 23, 25) which is arranged on the printed circuit board (10).

6. Device according to one of Claims 1 to 3, in which the holding-down means (30) comprises at least one spring element (40, 41, 42, 43, 44, 45) which is associated with a respective component (15, 17, 19, 21, 23, 25) and applies pressure.

7. Device according to one of the preceding claims, in which the support plate (10) is a printed circuit board and the connecting means is a solder.

8. Device according to one of the preceding claims, in which the housing component (12) is a cover which hermetically encloses the at least one component (15, 17, 19, 21, 23, 25) in a hollow space which is formed between the support plate (10) and the housing component (12).

9. Device according to Claim 8, in which the holding-down means (30) substantially completely fills the hollow space.

## Revendications

1. Appareil électrique (1), en particulier appareil de commande pour un véhicule automobile, comprenant :
- une platine support (10) sur laquelle est déposée une couche structurée électriquement conductrice, au moins un composant électrique (15, 17, 19, 21, 23, 25) étant relié à la couche électriquement conductrice (11) par l'intermédiaire d'un moyen d'assemblage,
- un élément de boîtier (12), disposé fixement par rapport à la platine support (10), qui entoure le ou lesdits composants (15, 17, 19, 21, 23, 25) montés sur la platine support (10), et
- un dispositif de retenue (30) qui s'appuie sur l'élément de boîtier (12) et exerce une pression sensiblement perpendiculaire sur le ou lesdits composants (15, 17, 19, 21, 23, 25) pour les plaquer contre la platine support (10),
**caractérisé en ce que** le dispositif de retenue (30) est constitué d'un matériau thermiquement résistant et conserve ses propriétés sans altération irréversible à des températures supérieures à 150 °C, de préférence supérieures à 160 °C, et **en ce que** le dispositif de retenue (30) comprend une couche (31 ; 39), faite d'un matériau expansé présentant au moins par endroits des propriétés élastiques, et au moins une autre couche pratiquement incompressible (38), la couche ayant des propriétés élastiques (31, 39) étant disposée entre l'élément de boîtier (12) et l'autre couche (38) ou entre l'autre couche (38) et le ou les composants (15, 17, 19, 21, 23, 25).

2. Appareil selon la revendication 1, dans lequel le dispositif de retenue (30) de chaque composant (15, 17, 19, 21, 23, 25) exerce une force sensiblement égale sur une pluralité de composants (15, 17, 19, 21, 23, 25).

3. Appareil selon la revendication 1 ou la revendication 2, dans lequel la couche (31 ; 39) est constituée d'une mousse de silicone.

4. Appareil selon l'une des revendications 1 à 3, dans lequel le dispositif de retenue (30) présente dans la zone du ou desdits composants (15, 17, 19, 21, 23, 25) une cavité (32, 33, 34) respective adaptée aux dimensions géométriques du composant (15, 17, 19, 21, 23, 25).

5. Appareil selon l'une des revendications 1 à 3, dans lequel le dispositif de retenue (30) est constitué d'un matériau compressible qui est disposé entre l'élément de boîtier (12) et la platine support (10) et qui épouse la structure du ou des composants (15, 17, 19, 21, 23, 25) disposés sur le circuit imprimé (10).

6. Appareil selon l'une des revendications 1 à 3, dans lequel le dispositif de retenue (30) comprend au moins un élément élastique (40, 41, 42, 43, 44, 45) qui est associé à un composant (15, 17, 19, 21, 23, 25) respectif et assure l'application de la pression.

7. Appareil selon l'une des revendications précédentes, dans lequel la platine support (10) est un circuit imprimé et le moyen d'assemblage est une soudure.

8. Appareil selon l'une des revendications précédentes, dans lequel l'élément de boîtier (12) est un couvercle qui enferme au moins un composant (15, 17, 19, 21, 23, 25) hermétiquement dans un creux formé entre la platine support (10) et l'élément de boîtier (12).

9. Appareil selon la revendication 8, dans lequel le dispositif de retenue (30) remplit pratiquement la totalité du creux.
